# EUROPEAN PATENT APPLICATION

(11) **EP 4 756 873 A1**
(43) Date of publication of application: **10.06.2026**
(21) Application number: 24857624.1
(22) Date of filing: 05.02.2024
(51) Int. Cl.: H01L 23/367, H01L 23/373, H01L 23/473, H01L 23/488, H01L 23/31, H01L 21/60, H01L 21/50, H01L 21/56, H02M 7/00, H02M 1/00, H02M 7/42

(54) **POWER MODULE AND MANUFACTURING METHOD THEREFOR, AND POWER DEVICE**

(30) Priority: 31.08.2023 CN 202311128988
(71) Applicant: Huawei Digital Power Technologies Co., Ltd., Shenzhen, Guangdong 518043 (CN)
(72) Inventor: TANG, Qingguo, Shenzhen, Guangdong 518043 (CN); LIU, Lu, Shenzhen, Guangdong 518043 (CN); TAO, Wei, Shenzhen, Guangdong 518043 (CN); DENG, Zhou, Shenzhen, Guangdong 518043 (CN)
(74) Representative: Isarpatent
(86) International application number: PCT/CN2024/075989
(87) International publication number: WO 2025/044067

(57) **Abstract**

This application provides a power module, a manufacturing method therefor, and a power device. The power module includes an integrated heat dissipation metal substrate, a chip, and a packaging element. The integrated heat dissipation metal substrate includes a copper layer, a thermally conductive medium layer, and a heat sink. The copper layer, the thermally conductive medium layer, and the heat sink are stacked, the thermally conductive medium layer is connected between the copper layer and the heat sink, and a surface of the thermally conductive medium layer close to the copper layer is parallel to a surface of the thermally conductive medium layer close to the heat sink. The chip is fastened on a side of the copper layer away from the heat sink, and the packaging element is configured to package the chip. In embodiments of this application, the integrated heat dissipation metal substrate is used, so that heat of the chip can be directly transferred from the chip to the integrated heat dissipation metal substrate, thereby reducing thermal resistance on a heat dissipation path of the chip. In addition, in embodiments of this application, functions such as circuit connection, heat dissipation, and insulation are integrated by directly using the integrated heat dissipation metal substrate, so that an assembly process for connecting a power component and the heat sink is omitted.

## Description

This application claims priority to Chinese Patent Application No. 202311128988.5, filed with the China National Intellectual Property Administration on August 31, 2023 and entitled "POWER MODULE, MANUFACTURING METHOD THEREFOR, AND POWER DEVICE", which is incorporated herein by reference in its entirety.

### TECHNICAL FIELD

This application relates to the chip processing field, and more specifically, to a power module, a manufacturing method therefor, and a power device.

### BACKGROUND

With development of electronic products toward densification, miniaturization, lightness, thinness, and high power, total density and heat generation per unit volume increase greatly. Therefore, a power component has an increasingly high requirement for heat dissipation on a heat link. Thermal conductivity of a material needs to be continuously improved. In addition, thermal resistance of the link needs to be reduced by reducing a contact interface. Currently, a power component and a heat sink are mainly connected by using a thermally conductive medium (for example, thermally conductive silicone grease or thermally conductive gel), which increases a heat dissipation interface and reduces heat transfer efficiency. In addition, the power component and the heat sink need to be fastened by using a screw, an assembly process is complex, and an architecture cannot be simplified.

### SUMMARY

This application provides a power module, a manufacturing method therefor, and a power device, to simplify a manufacturing process of the power module and improve heat dissipation efficiency of a chip.

According to a first aspect, a power module is provided, where the power module includes an integrated heat dissipation metal substrate, one or more chips, and a packaging element, where the integrated heat dissipation metal substrate includes one or more copper layers, a thermally conductive medium layer, and a heat sink, the one or more copper layers, the thermally conductive medium layer, and the heat sink are stacked, the thermally conductive medium layer is connected between the one or more copper layers and the heat sink, and a surface of the thermally conductive medium layer close to the one or more copper layers is parallel to a surface of the thermally conductive medium layer close to the heat sink; and each chip is connected to a side of one copper layer away from the heat sink, and the packaging element is configured to package the one or more chips.

In this embodiment of this application, the integrated heat dissipation metal substrate is used, so that heat of the chip can be directly transferred from the chip to the integrated heat dissipation metal substrate, thereby reducing thermal resistance on a heat dissipation path of the chip and improving heat dissipation efficiency of the chip. In addition, the surface of the thermally conductive medium layer close to the copper layer is parallel to the surface of the thermally conductive medium layer close to the heat sink, and a thickness of the thermally conductive medium layer is uniform and a surface thereof is flat, so that heat dissipation is more uniform, achieving a better thermally conductive effect. In addition, in this application, functions such as circuit connection, heat dissipation, and insulation are integrated by directly using the integrated heat dissipation metal substrate, so that an assembly process for connecting a power component and the heat sink is omitted, a connection interface is reduced, and a heat dissipation problem caused by an interface defect is resolved. In addition, because incoming materials are integrated, management costs of the power component, the heat sink, a thermally conductive insulation medium, and a fixture and a curing device used in the assembly process are reduced.

It should be noted that, when the packaging element is used to package the chip, a packaging manner may include plastic packaging, glue potting, glue dispensing, and the like, and a confined space is formed outside the chip to prevent the chip from being exposed, thereby protecting the chip and avoiding accidental damage to the chip in a running process.

In a possible implementation, the thermally conductive medium layer has a consistent thickness and has no intermediate air hole in a thickness direction, and the thickness direction is perpendicular to a contact surface between the thermally conductive medium layer and the heat sink.

In this implementation, the thermally conductive medium layer has a consistent thickness and has no intermediate air hole in the thickness direction. When heat of the chip is directly transferred to the heat sink through the thermally conductive medium layer, heat conduction on a heat dissipation path is more uniform, and a heat conduction effect is further improved, thereby further improving a heat dissipation effect of the chip.

In a possible implementation, the thermally conductive medium layer includes a side wall, and the side wall is perpendicular to the contact surface between the thermally conductive medium layer and the heat sink.

It should be understood that, in this embodiment of this application, the thermally conductive medium layer may be in a relatively regular shape such as a cube or a cuboid, and the side wall of the thermally conductive medium layer may be perpendicular to the contact surface between the thermally conductive medium layer and the heat sink, so as to facilitate processing and manufacturing of the thermally conductive medium layer.

In a possible implementation, a projection of the thermally conductive medium layer on a first plane completely overlaps a projection of the heat sink on the first plane, and the first plane is the contact surface between the thermally conductive medium layer and the heat sink.

In this implementation, the projection of the thermally conductive medium layer on the first plane completely overlaps the projection of the heat sink on the first plane, that is, an edge of the thermally conductive medium layer is flush with an edge of the heat sink, thereby facilitating processing.

In a possible implementation, the thermally conductive medium layer may be made of a polymer composite heat dissipation material, so that heat transfer efficiency of the chip can be improved, thereby improving heat dissipation efficiency of the chip.

For example, the thermally conductive medium layer may be an epoxy resin layer, a polyimide layer, or the like; the heat sink may be made of a copper material or an aluminum material; and the packaging element may be a plastic packaging adhesive.

In a possible implementation, the one or more copper layers include a first pad and a second pad, the one or more chips are welded to the first pad, and the one or more chips are interconnected to the second pad through wire bonding. The second pad may not be welded to the one or more chips, and the second pad may be connected to a circuit board or another component by using a pin.

For example, a conducting trace and a pad may be formed on the copper layer in an image transfer manner in cooperation with a chemical etching manner.

In this implementation, the chip and the pad to which the chip is not welded are interconnected through wire bonding, so that an electrical connection between the chip and the copper layer can be implemented, and the chip can be electrically connected to a circuit board or another component by using a pin for signal transmission. It should be understood that, to implement electrical signal transmission between chips, the chips may also be interconnected through wire bonding.

In a possible implementation, the packaging element is configured to independently package each chip and the copper layer connected to the chip. For example, the packaging element includes a first packaging element, the one or more chips include a first chip, and the first packaging element is configured to independently package the first chip and a copper layer connected to the first chip. In other words, there may be a plurality of packaging elements, and a single packaging element may independently package a single chip and a copper layer connected to the single chip. It should be understood that, by using an independent packaging manner, use of a material of a plastic packaging element can be reduced while the chip is protected, thereby reducing costs.

In an example, the one or more copper layers include a first copper sub-layer, and a plurality of chips may be welded to the first copper sub-layer. In this case, the first copper sub-layer and the plurality of chips welded to the first copper sub-layer may be packaged as a whole.

In an example, a packaging element may be further used to package a plurality of chips having a same function or similar functions and a copper layer connected to the plurality of chips as a whole, so that the chips having the same function or the similar functions are located in a same packaging element, thereby facilitating subsequent processing.

It should be understood that, in some embodiments, a single chip and a pad welded to the single chip may be independently packaged by using a packaging element, and a copper layer on which a conducting trace is disposed may be independently packaged by using a packaging element. In other words, the copper layer may include a first copper sub-layer and a second copper sub-layer, the first copper sub-layer is configured to dispose the chip, and the second copper sub-layer is configured for conducting wire connection. The packaging element is configured to independently package a single chip and the first copper sub-layer corresponding to the single chip, and independently package the second copper sub-layer.

In another possible implementation, the packaging element is configured to package the one or more chips and the one or more copper layers as a whole, that is, the packaging element is used to wrap the entire copper layer and at least one chip disposed on the copper layer. It should be understood that, in this implementation, a line on the copper layer and a chip welded on the copper layer can be protected by using the packaging element, so that an overall structure is more stable.

In still another possible implementation, the packaging element is configured to package the one or more chips, the one or more copper layers, and the thermally conductive medium layer as a whole. That is, the chip, the copper layer, the thermally conductive medium layer, and the surface of the heat sink are packaged as a whole by using the packaging element, so that a structure of the entire power module is more stable, but use costs of the plastic packaging element are also correspondingly increased.

In a possible implementation, the one or more copper layers include a pad, the power module further includes a pin that is disposed outward after passing through the packaging element, one end of the pin is electrically connected to the pad, and the other end of the pin is configured to be electrically connected to a circuit board. It should be understood that an electrical connection between an internal chip of the power module and an external component (for example, a circuit board) can be implemented by disposing a pin.

For example, the pin may pass through the packaging element and be led out in a seagull wing shape (that is, a small outline package manner is used), or the pin may pass through the packaging element and be disposed outward in parallel (that is, a dual-in-line package manner).

In a possible implementation, the heat sink may be of a pin-shaped structure, that is, the heat sink may be of a pin-fin heat dissipation structure. In other words, a heat sink tooth of the heat sink may be of a cylindrical or square column structure, so that a larger heat dissipation area can be obtained, and heat dissipation efficiency of the chip can be improved.

In another possible implementation, the heat sink may be of a fin-shaped structure, that is, a heat sink tooth structure of the heat sink is similar to a thin sheet shape. It should be understood that, compared with the pin-fin heat dissipation structure, the heat sink tooth of the heat sink of the fin-shaped structure has a smaller width, a relatively small heat dissipation area, and a relatively poor heat dissipation effect.

In still another possible implementation, the heat sink may be of a flow channel structure. That is, heat transferred by the chip to the heat sink may be taken away by using flow of a coolant in a flow channel, so that a higher heat dissipation effect can be obtained, and heat dissipation efficiency of the chip is further improved.

According to a second aspect, a manufacturing method for a power module is provided, where the manufacturing method includes: obtaining an integrated heat dissipation metal substrate, where the integrated heat dissipation metal substrate includes a first copper layer, a thermally conductive medium layer, and a first heat sink, the first copper layer, the thermally conductive medium layer, and the first heat sink are stacked, the thermally conductive medium layer is connected between the first copper layer and the first heat sink, and a surface of the thermally conductive medium layer close to the first copper layer is parallel to a surface of the thermally conductive medium layer close to the first heat sink; welding the chip to a side of the first copper layer away from the first heat sink; and packaging the chip by using a packaging element.

There may be one or more chips, and there may be one or more first copper layers. This is not limited in this application.

According to the manufacturing method provided in this embodiment of this application, the integrated heat dissipation metal substrate is directly obtained to manufacture and process the power module, that is, a process of manufacturing, chip welding, and plastic packaging by using the integrated heat dissipation metal substrate is used. Compared with a conventional technology, assembly steps are reduced. In addition, functions such as circuit connection, heat dissipation, and insulation are integrated by directly using the integrated heat dissipation metal substrate, thereby reducing an assembly process of connecting a power component to a heat sink in the conventional technology, reducing a connection interface, and resolving a heat dissipation problem caused by an interface defect. In addition, because incoming materials are integrated, management costs of a power component, a heat sink, a thermally conductive insulation medium, and a fixture and a curing device used in the assembly process are reduced.

It should be noted that in this embodiment of this application, the integrated heat dissipation metal substrate may be obtained in the following three manners.

In a possible implementation, the obtaining an integrated heat dissipation metal substrate includes: obtaining a first metal substrate, where the first metal substrate includes a second copper layer, the thermally conductive medium layer, and a first metal base, the second copper layer, the thermally conductive medium layer, and the first metal base are stacked, and the thermally conductive medium layer is connected between the second copper layer and the first metal base; performing trace pattern manufacturing on the second copper layer to form the first copper layer; and manufacturing the first heat sink on the first metal base.

In another possible implementation, the obtaining an integrated heat dissipation metal substrate includes: obtaining a second copper layer, the thermally conductive medium layer, and the first heat sink; press-fitting the second copper layer, the thermally conductive medium layer, and the first heat sink; and performing trace pattern manufacturing on the second copper layer to form the first copper layer.

In still another possible implementation, the obtaining an integrated heat dissipation metal substrate includes: obtaining a second metal substrate, where the second metal substrate includes a second copper layer, the thermally conductive medium layer, and a second metal base, the second copper layer, the thermally conductive medium layer, and the second metal base are stacked, and the thermally conductive medium layer is connected between the second copper layer and the second metal base; and performing trace pattern manufacturing on the second copper layer to form the first copper layer; and fastening the second metal base and the second heat sink, so as to form the first heat sink. The second heat sink is of a pin-shaped structure, or the second heat sink is of a fin-shaped structure, or the second heat sink is of a flow channel structure.

The fastening the second metal base and the second heat sink to form the first heat sink may include: fastening the second metal base and the second heat sink in a laser welding manner, to form the first heat sink.

The integrated heat dissipation metal substrate may be obtained in all the foregoing three manufacturing manners. It should be understood that in this embodiment of this application, the integrated heat dissipation metal substrate may be directly manufactured through processing or may be manufactured through self-processing by separately obtaining incoming materials. The integrated heat dissipation metal substrate is obtained, and the power module is formed by processing the integrated heat dissipation metal substrate. A process becomes simpler, and manufacturing efficiency is high, which is conducive to lean manufacturing.

In a possible implementation, the packaging the chip by using a packaging element includes: independently packaging, by using the packaging element, a single chip and a first copper layer corresponding to the single chip; or packaging, by using the packaging element, a plurality of chips and the first copper layer as a whole; or packaging, by using the packaging element, the chip, the first copper layer, and the thermally conductive medium layer as a whole.

It should be noted that, when the packaging element is used to package the chip, a packaging manner may include a packaging manner such as plastic packaging, glue potting, and glue dispensing, and a confined space is formed outside the chip, thereby protecting the chip and avoiding accidental damage to the chip in a running process.

In a possible implementation, a conducting trace and a pad are formed on the first copper layer, and the welding a chip on a side of the first copper layer away from the first heat sink includes: welding the chip on the pad on the first copper layer; and before the packaging the chip by using a packaging element, the method further includes: interconnecting through wire bonding the chip and a pad to which the chip is not welded.

In a possible implementation, a conducting trace and a pad are formed on the first copper layer, and before the packaging the chip by using a packaging element, the method further includes: performing pin welding, where one end of the pin is electrically connected to the pad, and the other end of the pin is configured to be electrically connected to a circuit board.

According to a third aspect, a power device is provided, where the power device is configured to perform alternating current-direct current conversion, the power device includes a circuit board and the power module according to any one of the first aspect and the implementations of the first aspect, or the power device includes a circuit board and the power module manufactured according to any one of the second aspect and the implementations of the second aspect, and the power module is disposed on the circuit board.

It should be noted that, for beneficial effects of the second aspect and the third aspect, refer to the first aspect. Details are not described herein again.

### BRIEF DESCRIPTION OF DRAWINGS

FIG. 1 is a diagram of a structure of a power module according to an embodiment of this application;
FIG. 2 is a diagram of a structure of another power module according to an embodiment of this application;
FIG. 3 is a diagram of a structure of another power module according to an embodiment of this application;
FIG. 4 is a diagram of a structure of another power module according to an embodiment of this application;
FIG. 5 is a diagram of a structure of a power module according to an embodiment of this application;
FIG. 6 is a diagram of a structure of different heat sinks according to an embodiment of this application;
FIG. 7 is a diagram of a structure of different power modules according to an embodiment of this application;
FIG. 8 is a diagram of a manufacturing method for a power module according to an embodiment of this application;
FIG. 9 is a diagram of a manufacturing method for an integrated heat dissipation metal substrate according to an embodiment of this application;
FIG. 10 is a diagram of another manufacturing method for an integrated heat dissipation metal substrate according to an embodiment of this application; and
FIG. 11 is a diagram of another manufacturing method for an integrated heat dissipation metal substrate according to an embodiment of this application.

### DESCRIPTION OF EMBODIMENTS

The following describes technical solutions of this application with reference to accompanying drawings.

For ease of understanding of embodiments of this application, the following descriptions are first provided before embodiments of this application are described.

The terms "first" and "second" in embodiments of this application are merely intended for a purpose of description, and shall not be understood as an indication or implication of relative importance or implicit indication of a quantity of indicated technical features. Therefore, a feature limited by "first" and "second" may wisely or implicitly include one or more features. In addition, in the descriptions of embodiments of this application, "a plurality of" means two or more, and "at least one" and "one or more" mean one, two, or more. The singular expression forms "one", "a", "the", "the foregoing", "this", and "the one" are also intended to include an expression form such as "one or more", unless the opposite is explicitly indicated in the context thereof. Sequence numbers of the following processes do not mean an execution sequence. The execution sequence of the processes should be determined based on functions and internal logic of the processes, and should not constitute any limitation on an implementation process of embodiments of this application. For example, in embodiments of this application, the terms "110", "120", "130", and the like are merely identifiers for ease of description, and are not intended to limit an execution sequence of steps.

Reference to "one embodiment", "some embodiments", or the like described in this specification means that a specific feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

Currently, with development of electronic products toward densification, miniaturization, lightness, thinness, and high power, total density and heat generation per unit volume increase greatly. Therefore, a power component has an increasingly high requirement for heat dissipation on a heat link. Thermal conductivity of a material needs to be continuously improved. In addition, thermal resistance of the link needs to be reduced by reducing a contact interface. Currently, the power component and a heat sink are mainly connected by using a thermally conductive medium (for example, thermally conductive silicone grease or thermally conductive gel), so as to transfer heat to the heat sink for the heat sink to dissipate heat.

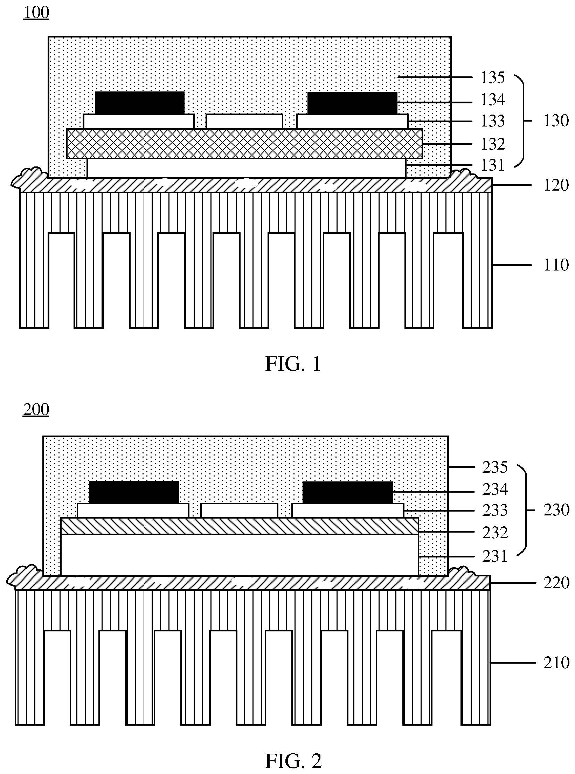

FIG. 1 to FIG. 4 are diagrams of structures of a power module according to an embodiment of this application.

In some embodiments, if a power component has an insulation function, a heat sink and the power component may be fastened by using a thermally conductive medium (for example, thermally conductive silicone grease or thermally conductive gel), that is, the power component and the heat sink may be assembled together by using the thermally conductive medium.

As shown in FIG. 1, a power component 130 may have an insulation function, and a heat sink 110 and the power component 130 may be fastened by using a thermally conductive medium 120, that is, the power component 130 and the heat sink 110 may be assembled together by using the thermally conductive medium 120.

The power component 130 may be a DBC (direct bonded copper) module, and the DBC module may include a copper layer 131, a ceramic substrate 132 disposed on the copper layer 131, a copper layer 133 disposed on the ceramic substrate 132, a chip 134 disposed on the copper layer 133, and a packaging element 135. That is, the copper layer 131, the ceramic substrate 132, the copper layer 133, and the chip 134 are sequentially disposed from bottom to top along a thickness direction of the power component 130. A corresponding trace pattern may be formed on the copper layer 133. The chip 134 may be welded on a surface of a side that is of the copper layer 133 and that is away from the ceramic substrate 132. The packaging element 135 surrounds the copper layer 131, the ceramic substrate 132, the copper layer 133, and the chip 134 to form a confined space, so as to prevent the chip 134 from being exposed.

The copper layer 131, the ceramic substrate 132, and the copper layer 133 may form a DBC ceramic substrate. It should be understood that the DBC ceramic substrate uses a DBC manufacturing process, and a copper foil is sintered and coated on the ceramic substrate 132.

In this example, a heat dissipation path of the chip 134 may be: chip 134-copper layer 133-ceramic substrate 132-copper layer 131-thermally conductive medium layer 120-heat sink 110, so as to complete heat dissipation of the chip 134.

A method for processing a power module 100 may include: first performing pattern manufacturing on the DBC ceramic substrate to form a specific conducting trace and a pad; then welding the chip 134 to the pad on the DBC ceramic substrate; then using the packaging element 135 to complete plastic packaging to obtain the DBC module; and finally assembling the DBC module and the heat sink 110 by using the thermally conductive medium 120. That is, the manufacturing process may be summarized as: pattern manufacturing on the DBC ceramic substrate -chip welding -plastic packaging -assembly.

Similarly, in the structure shown in FIG. 2, the DBC module in FIG. 1 may be replaced with a copper substrate module. That is, in some embodiments, the power component 130 in FIG. 1 may be replaced with a power component 230 in FIG. 2, the power component 230 may have an insulation function, and a heat sink 210 and the power component 230 may be fastened by using a thermally conductive medium 220. The copper substrate module 230 may include a copper layer 231, an insulating and thermally conductive layer 232 disposed on the copper layer 231, a copper layer 233 disposed on the insulating and thermally conductive layer 232, a chip 234 disposed on the copper layer 233, and a packaging element 235 that surrounds the copper layer 231, the insulating and thermally conductive layer 232, the copper layer 233, and the chip 234. The copper layer 231, the insulating and thermally conductive layer 232, and the copper layer 233 may form a copper substrate.

In the example in FIG. 2, a heat dissipation path of the chip 234 may be: chip 234-copper layer 233-insulating and thermally conductive layer 232-copper layer 231-thermally conductive medium 220- -heat sink 210, so as to complete heat dissipation of the chip 234.

A method for processing a power module 200 may include: first performing pattern manufacturing on the copper substrate to form a specific conducting trace and a pad; then welding the chip 234 to the pad on the copper substrate; then using the packaging element 235 to complete plastic packaging to obtain the copper substrate module; and finally assembling the copper substrate module and the heat sink 220 by using the thermally conductive medium 220. That is, the manufacturing process may be summarized as: pattern manufacturing on the copper substrate-chip welding -plastic packaging -assembly.

In some other embodiments, if the power component has no insulation function, the heat sink and the power component may be fastened by using a thermally conductive insulation medium (for example, an insulation film or a PI film), that is, the power component and the heat sink may be assembled together by using the thermally conductive insulation medium.

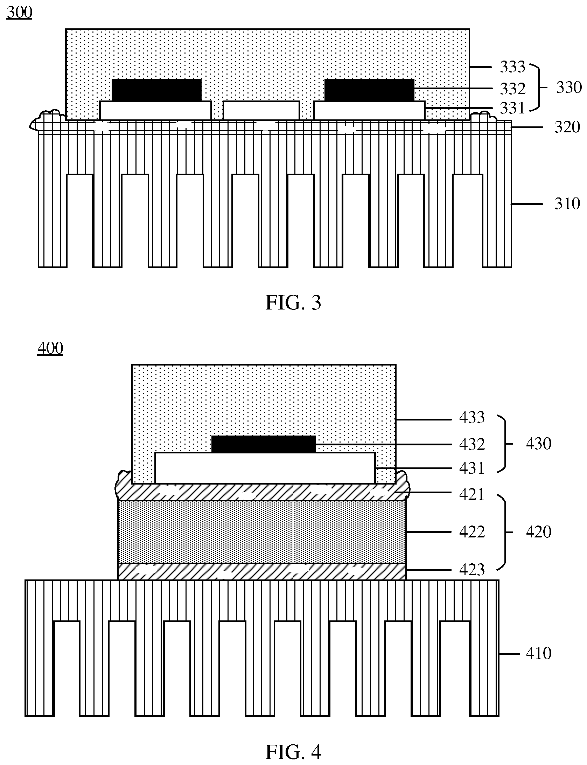

As shown in FIG. 3, a power component 330 has no insulation function, and the power component 330 and a heat sink 310 may be fastened by using a thermally conductive insulation medium 320, where the thermally conductive insulation medium 320 may be an insulation film or a PI film.

The power component 330 may include a copper layer 331, a chip 332, and a packaging element 333. A corresponding trace pattern may be formed on the copper layer 333, the chip 332 may be welded on the copper layer 331, and the packaging element 333 surrounds the copper layer 331 and the chip 332 to form a confined space, so as to prevent the chip 332 from being exposed.

In this example, a heat dissipation path of the chip 332 may be: chip 332-copper layer 331-thermally conductive insulation medium 320-heat sink 310, so as to complete heat dissipation of the chip 332.

A method for processing the power module 300 may include: first performing pattern manufacturing on the copper layer 331 to form a specific conducting trace and a pad; then welding the chip 332 to the pad on the copper layer 331; then using the packaging element 333 to complete plastic packaging to obtain the power component 330; and finally assembling the power component 330 and the heat sink 310 by using the thermally conductive insulation medium 320. That is, the manufacturing process may be summarized as: pattern manufacturing on the copper layer--chip welding -plastic packaging -assembly.

Similar to FIG. 3, in FIG. 4, a power component 430 has no insulation function, and the power component 430 and a heat sink 410 may be fastened by using a thermally conductive insulation medium 420, where the thermally conductive insulation medium 420 may include a thermally conductive layer 421, a ceramic sheet 422 (thickness is about 1 mm), and a thermally conductive layer 423, and the thermally conductive layer 421, the ceramic sheet 422, and the thermally conductive layer 423 are stacked, the ceramic sheet 422 is connected between the thermally conductive layer 421 and the thermally conductive layer 432, and the thermally conductive layer 421 is fastened to a copper layer 431. The thermally conductive layer 421 and the thermally conductive layer 423 may be thermally conductive silicone.

In this example, a heat dissipation path of the chip 432 may be: chip 432 copper layer 431-thermally conductive insulation medium 420-heat sink 410, so as to complete heat dissipation of the chip 432.

A method for processing the power module 400 may include: first performing pattern manufacturing on the copper layer 431 to form a specific conducting trace and a pad; then welding the chip 432 to the pad on the copper layer 431; then using the packaging element 433 to complete plastic packaging to obtain the power component 430; and finally assembling the power component 430 and the heat sink 410 by using the thermally conductive insulation medium 420. That is, the manufacturing process may be summarized as: pattern manufacturing on the copper layer--chip welding -plastic packaging -assembly.

It should be noted that, the power component and the heat sink in FIG. 1 to FIG. 4 may be from different manufacturers, and may be assembled in an EMS (electronic manufacturing service) factory. In addition, the power component and the heat sink are bonded by using a thermally conductive insulation layer, which causes thermal resistance on an interface. In addition, a bonding process requires a large amount of labor and material resources, and defects such as poor bonding and bubbles are likely to occur. The process is complex, and manufacturing efficiency is low, which is unfavorable to lean manufacturing.

Regardless of whether the power component has an insulation function or has no insulation function, a thermally conductive medium needs to be used for heat transfer from the power component to the heat sink, which increases a contact interface and reduces heat transfer efficiency. For example, thermally conductive silicone grease/gel, an insulation film, and a PI film need to consider processibility, and problems such as a ceramic sheet being prone to cracking necessitate an increased thickness, which cannot come at the expense of sacrificing thermal conductivity. This leads to an increase in thermal resistance within the thermal conducting link. A packaging manner of an incoming material of the power component is single, and the power component and the heat sink need to be fastened by using a screw. An assembly process is complex, and an architecture cannot be simplified.

Therefore, embodiments of this application provide a power module, a manufacturing method therefor, and a power device, to resolve problems in an existing overall assembly process in which a power component and a heat sink are bonded by using a thermally conductive insulating medium, including an inability to meet a heat dissipation requirement due to an increased thermally conductive interface, a heat dissipation link failure caused by an interface defect, a complex assembly process, low production and manufacturing efficiency, and increased management costs due to multitude of material components.

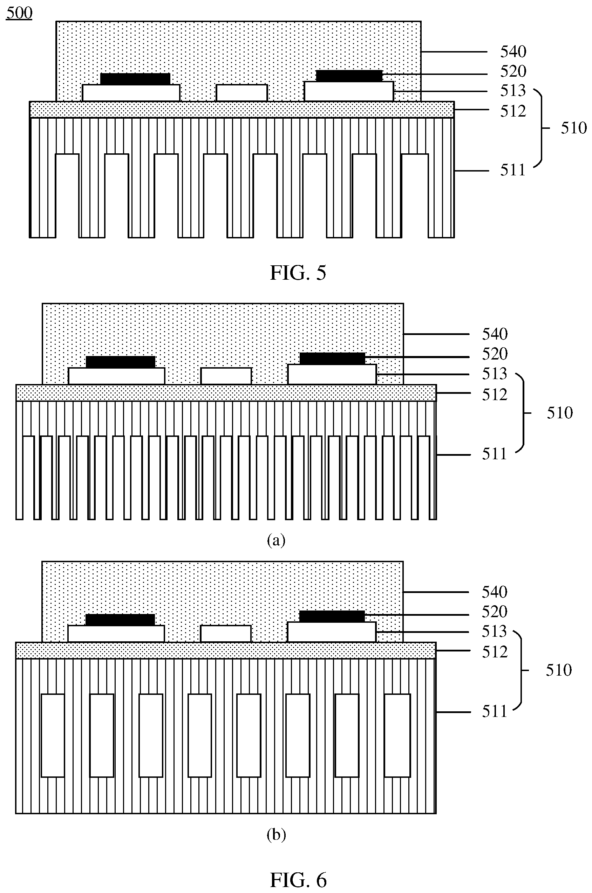

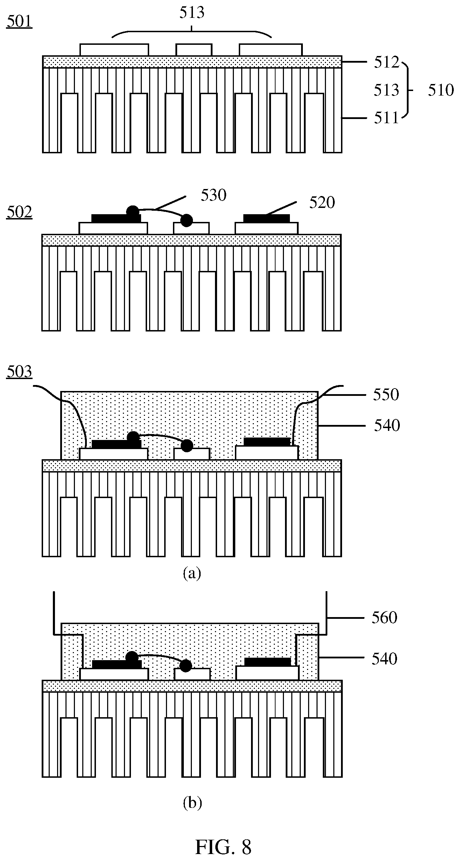

The following describes, with reference to FIG. 5 to FIG. 7, a diagram of a structure of a power module according to an embodiment of this application, and describes in detail, with reference to FIG. 8 to FIG. 11, a manufacturing method for a power module according to an embodiment of this application.

FIG. 5 is a diagram of a structure of a power module according to an embodiment of this application.

As shown in FIG. 5, a power module 500 may include an integrated heat dissipation metal substrate 510, a chip 520, and a packaging element 540. The integrated heat dissipation metal substrate 510 includes a copper layer 513, a thermally conductive medium layer 512, and a heat sink 511. The copper layer 513, the thermally conductive medium layer 512, and the heat sink 511 are stacked, the thermally conductive medium layer 512 is connected between the copper layer 513 and the heat sink 511, and a surface of the thermally conductive medium layer 512 close to the copper layer 513 is parallel to a surface of the thermally conductive medium layer 512 close to the heat sink 511. The chip 520 is fastened on a side of the copper layer 513 away from the heat sink 511, and the packaging element 540 is configured to package the chip 520. There may be one or more chips 520, the copper layer 513 may include one or more copper sub-layers, and some copper sub-layers of the one or more copper sub-layers may be welded to a chip by using a pad, or may not be welded to a chip. This is not limited in this application.

In this embodiment of this application, the integrated heat dissipation metal substrate is used, so that heat of the chip can be directly transferred from the chip to the integrated heat dissipation metal substrate, thereby reducing thermal resistance on a heat dissipation path of the chip and improving heat dissipation efficiency of the chip. In addition, the surface of the thermally conductive medium layer close to the copper layer is parallel to the surface of the thermally conductive medium layer close to the heat sink, and a thickness of the thermally conductive medium layer is uniform and a surface thereof is flat, so that heat dissipation is more uniform, achieving a better thermally conductive effect. In addition, in this application, functions such as circuit connection, heat dissipation, and insulation are integrated by directly using the integrated heat dissipation metal substrate, so that an assembly process for connecting a power component and the heat sink is omitted, a connection interface is reduced, and a heat dissipation problem caused by an interface defect is resolved. In addition, because incoming materials are integrated, management costs of the power component, the heat sink, a thermally conductive insulation medium, and a fixture and a curing device used in the assembly process are reduced.

It should be noted that, when the packaging element 540 is used to package the chip 520, a packaging manner may include a packaging manner such as plastic packaging, glue potting, and glue dispensing, and a confined space is formed outside the chip 520, thereby protecting the chip 520 and avoiding accidental damage to the chip 520 in a running process.

In some embodiments, the thermally conductive medium layer 512 has a consistent thickness and has no intermediate air hole in a thickness direction, and the thickness direction is perpendicular to a contact surface between the thermally conductive medium layer 512 and the heat sink 511.

In this embodiment, the thermally conductive medium layer 512 has a consistent thickness and has no intermediate air hole in the thickness direction. When heat of the chip 520 is directly transferred to the heat sink 511 through the thermally conductive medium layer 512, heat conduction on a heat dissipation path is more uniform, and a heat conduction effect is further improved, thereby further improving a heat dissipation effect of the chip 520.

In some embodiments, the thermally conductive medium layer 512 includes a side wall, and the side wall is perpendicular to the contact surface between the thermally conductive medium layer 512 and the heat sink 511.

It should be understood that, in this embodiment of this application, the thermally conductive medium layer 512 may be in a relatively regular shape such as a cube or a cuboid, and the side wall of the thermally conductive medium layer 512 may be perpendicular to the contact surface between the thermally conductive medium layer 512 and the heat sink 511, so as to facilitate processing and manufacturing of the thermally conductive medium layer 512.

In some embodiments, a projection of the thermally conductive medium layer 512 on a first plane completely overlaps a projection of the heat sink 511 on the first plane, and the first plane is the contact surface between the thermally conductive medium layer 512 and the heat sink 511.

In this implementation, the projection of the thermally conductive medium layer 512 on the first plane completely overlaps the projection of the heat sink 511 on the first plane, that is, an edge of the thermally conductive medium layer 512 is flush with an edge of the heat sink 511, thereby facilitating processing.

In some embodiments, the thermally conductive medium layer 512 may be made of a polymer composite heat dissipation material. For example, the thermally conductive medium layer 512 may be an epoxy resin layer, a polyimide layer, or the like.

In some embodiments, a structure of the heat sink 511 may be shown in FIG. 5. The heat sink 511 may be processed to form a pin-shaped (pin-fin) heat dissipation structure. In other words, a heat sink tooth of the heat sink 511 may be of a cylindrical or square column structure, so that a larger heat dissipation area can be obtained, and heat dissipation efficiency of the chip can be improved.

In some other embodiments, the structure of the heat sink 511 may be shown in (a) in FIG. 6. The heat sink 511 may be processed to form a fin heat dissipation structure. That is, a heat sink tooth structure of the heat sink 511 is similar to a thin sheet shape. Compared with the pin-fin heat dissipation structure, the heat sink tooth of the heat sink of the fin structure has a smaller width, a relatively small heat dissipation area, and a relatively poor heat dissipation effect.

In still some other embodiments, the structure of the heat sink 511 may be shown in (b) in FIG. 6, and the heat sink 511 may use a heat dissipation structure in a flow channel form. For example, a coolant inlet may be disposed on a side of the heat sink 511 close to the chip 520, a coolant outlet may be disposed on a side of the heat sink 511 away from the chip 520, and a plurality of pipeline channels may be disposed in the middle of the heat sink 511. A coolant may enter the heat sink 511 from the inlet, be output from the heat sink 511 through the outlet, dissipate heat outside the heat sink 511, and then enter the heat sink 511 from the inlet, so as to implement circulation of the coolant, thereby taking away heat transferred by the chip 520 to the heat sink 511. That is, heat transferred by the chip 520 to the heat sink 511 may be taken away by using flow of a coolant in a flow channel, so that a higher heat dissipation effect can be obtained, and heat dissipation efficiency of the chip 520 is further improved.

In some embodiments, the packaging element 540 is configured to independently package each chip and the copper layer connected to the chip. For example, the packaging element 540 may include a first packaging element, the one or more chips may include a first chip, and the first packaging element is configured to independently package the first chip and a copper layer connected to the first chip. That is, the packaging element 540 may be configured to independently package a single chip and a copper layer connected to the single chip.

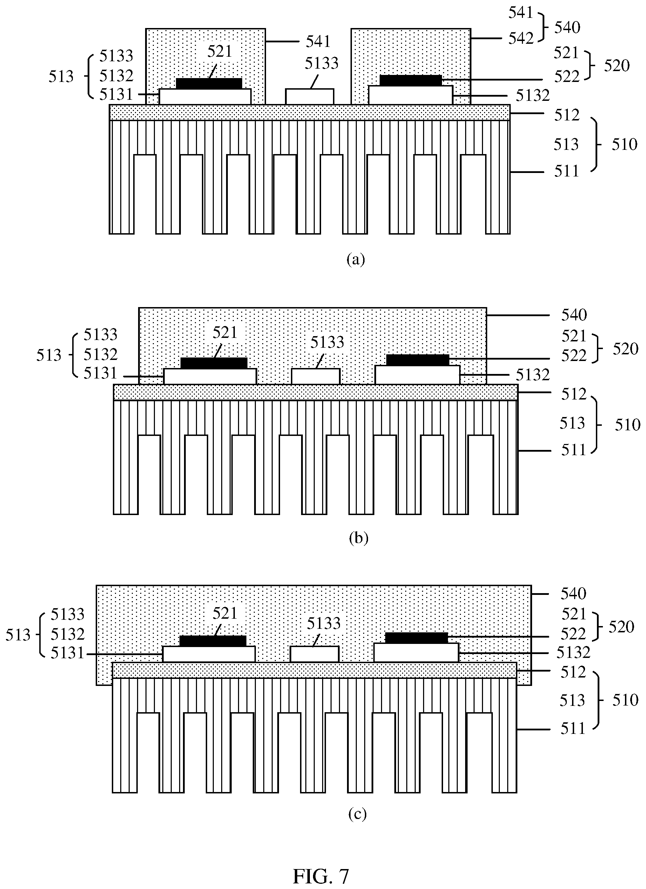

As shown in (a) in FIG. 7, a chip 520 may include a first chip 521 and a second chip 522, and a copper layer 513 may include a first copper sub-layer 5131, a second copper sub-layer 5132, and a third copper sub-layer 5133. The first chip 521 is welded to the first copper sub-layer 5131, the second chip 522 is welded to the second copper sub-layer 5132, and no chip is welded to the third copper sub-layer 5133. When the first chip 521 and the second sub-chip 522 are packaged, a single chip and a copper layer connected to the single chip may be independently packaged by using a packaging element 540. That is, the packaging element 540 may include a first packaging element 541 and a second packaging element 542, the first chip 521 and the first copper sub-layer 5131 connected to the first chip 521 may be packaged by using the first packaging element 541, and the second chip 522 and the second copper sub-layer 5132 connected to the second chip 522 may be packaged by using the second packaging element 542. It should be understood that, by using an independent packaging manner, use of a material of a plastic packaging element can be reduced while the chip is protected, thereby reducing costs.

In an example, the copper layer 513 may include a first copper sub-layer, and a plurality of chips may be welded to the first copper sub-layer. In this case, the first copper sub-layer and the plurality of chips welded to the first copper sub-layer may be packaged as a whole.

In an example, the packaging element 540 may be further used to package a plurality of chips having a same function or similar functions and a copper layer connected to the plurality of chips as a whole, so that the chips having the same function or the similar functions are located in a same packaging element, thereby facilitating subsequent processing.

It should be understood that, in some embodiments, a single chip and a pad welded to the single chip may be independently packaged by using the packaging element 540, and a copper layer on which a conducting trace is disposed may be independently packaged by using a packaging element. In other words, the copper layer 513 may include a first copper sub-layer and a second copper sub-layer, the first copper sub-layer is configured to dispose the chip 520, and the second copper sub-layer is configured for conducting wire connection. The packaging element 540 is configured to independently package a single chip and the first copper sub-layer corresponding to the single chip, and independently package the second copper sub-layer.

In some other embodiments, the packaging element 540 may be configured to package one or more chips and one or more copper layers as a whole.

As shown in (b) in FIG. 7, a chip 520 may include a first chip 521 and a second chip 522, and a copper layer 513 may include a first copper sub-layer 5131, a second copper sub-layer 5132, and a third copper sub-layer 5133. The first chip 521 is welded to the first copper sub-layer 5131, the second chip 522 is welded to the second copper sub-layer 5132, and no chip is welded to the third copper sub-layer 5133. When the first chip 521 and the second chip 522 are packaged, the first chip 521 and the second chip 522 may be packaged at the same time, that is, one packaging element 540 is used to package the first chip 521, the second chip 522, the first copper sub-layer 5131 connected to the first chip 521, and the second copper sub-layer 5132 connected to the second chip 522 as a whole. It should be understood that, in this example, the packaging element 540 may be used to protect the chip 520 welded on the copper layer 513 and a conducting trace on the copper layer 513, so that an overall structure is more stable.

In still some other embodiments, the packaging element 540 may be configured to package one or more chips, one or more copper layers, and a thermally conductive medium layer 512 as a whole.

As shown in (c) in FIG. 7, a chip 520 may include a first chip 521 and a second chip 522, and a copper layer 513 may include a first copper sub-layer 5131, a second copper sub-layer 5132, and a third copper sub-layer 5133. The first chip 521 is welded to the first copper sub-layer 5131, the second chip 522 is welded to the second copper sub-layer 5132, and no chip is welded to the third copper sub-layer 5133. When the first chip 521 and the second chip 522 are packaged, overall packaging may be adopted, that is, the first chip 521, the second chip 522, the copper layer 513, and the thermally conductive medium layer 512 are packaged as a whole by using the packaging element 540, so that a structure of an entire power module is more stable, but use costs of a plastic packaging material are also increased accordingly.

In some embodiments, a pad is formed on the copper layer 513, the pad includes a first pad and a second pad, the one or more chips are welded to the first pad, and the one or more chips are interconnected to the second pad through wire bonding. The second pad may not be welded to the one or more chips, and the second pad may be connected to a circuit board or another component by using a pin. That is, a conducting trace and a pad are formed on the copper layer 513, the chip 520 may be welded on the pad, and the chip 520 may be interconnected through wire bonding to a pad to which the chip is not welded.

It should be understood that, the chip 520 and the pad to which the chip is not welded are interconnected through wire bonding, so that an electrical connection between the chip 520 and the copper layer 513 can be implemented, and the chip can be electrically connected to a circuit board or another component by using a pin for signal transmission.

It should be further understood that, to implement electrical signal transmission between chips, the chips may also be interconnected through wire bonding.

In some embodiments, a conducting trace and a pad are formed on the copper layer 513, and the power module 500 may further include a pin that is disposed outward after passing through the packaging element 540, one end of the pin is electrically connected to the pad, and the other end of the pin is configured to be electrically connected to a circuit board. In an example, as shown in (a) in FIG. 8, a pin 550 may pass through a packaging element 540 and be led out in a seagull wing shape. In another example, as shown in (b) in FIG. 8, a pin 560 may pass through a packaging element 540 and be disposed outward in parallel.

It should be noted that, in the power module 500 provided in this embodiment of this application, the integrated heat dissipation metal substrate 510 is used, so that heat of the chip 520 can be directly transferred from the chip 520 to the integrated heat dissipation metal substrate 510, so that heat dissipation of the chip 520 can be completed, thereby reducing thermal resistance on a heat dissipation path of the chip 520, and improving heat dissipation efficiency of the chip 520.

FIG. 8 is a diagram of a manufacturing method for a power module according to an embodiment of this application.

501: Obtain an integrated heat dissipation metal substrate 510.

The integrated heat dissipation metal substrate 510 may include a heat sink 511, a thermally conductive medium layer 512, and a copper layer 513. A trace pattern is formed on the upper layer, namely, the copper layer 513, that is, a conducting trace and a pad are formed, and a thickness is about 0 mm to 2 mm. The lower layer is the heat sink 511, and may be configured to dissipate heat for a chip. The middle layer is the thermally conductive medium layer 512, and the thermally conductive medium layer 512 meets heat conduction and insulation characteristics, and implements insulation between the trace pattern on the upper layer and the heat sink on the lower layer, and a heat dissipation link is formed from top to bottom.

The heat sink 511 may be made of a metal material (for example, aluminum or copper), and a tooth-like pattern required by the heat sink may be manufactured in a machining or etching manner for the heat sink 511. It should be understood that the heat sink 511 may have various architectures, for example, in a form of a pin, a fin, or a flow channel. For a specific structure of the heat sink 511, refer to FIG. 6.

The copper layer 513, the thermally conductive medium layer 512, and the heat sink 511 are stacked. The thermally conductive medium layer 512 is located between the copper layer 513 and the heat sink 511, and a side of the thermally conductive medium layer 512 close to the copper layer 513 is parallel to a side of the thermally conductive medium layer 512 close to the heat sink 111.

In some embodiments, the thermally conductive medium layer 512 has a consistent thickness and has no intermediate air hole in a thickness direction, and the thickness direction is perpendicular to a contact surface between the thermally conductive medium layer 512 and the heat sink 111.

In some embodiments, the thermally conductive medium layer 512 includes a side wall, and the side wall is perpendicular to the contact surface between the thermally conductive medium layer 512 and the heat sink 511. It should be understood that, in this embodiment of this application, the thermally conductive medium layer 512 may be in a relatively regular shape such as a cube or a cuboid, and the side wall of the thermally conductive medium layer 512 may be perpendicular to the contact surface between the thermally conductive medium layer 512 and the heat sink 511, so as to facilitate processing and manufacturing of the thermally conductive medium layer 512.

In some embodiments, a projection of the thermally conductive medium layer 512 on a first plane completely overlaps a projection of the heat sink 511 on the first plane, and the first plane is the contact surface between the thermally conductive medium layer 512 and the heat sink 511. In this embodiment, the projection of the thermally conductive medium layer 512 on the first plane completely overlaps the projection of the heat sink 511 on the first plane, that is, an edge of the thermally conductive medium layer 512 is flush with an edge of the heat sink 511, thereby facilitating processing.

In some embodiments, the thermally conductive medium layer 512 may be made of a polymer composite heat dissipation material. For example, the thermally conductive medium layer 512 may be an epoxy resin layer, a polyimide layer, or the like.

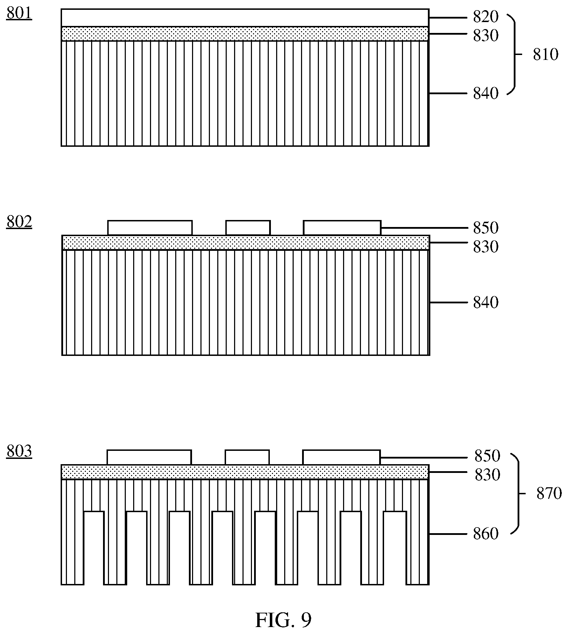

It should be noted that a manufacturing method for the integrated heat dissipation metal substrate 510 is described with reference to FIG. 9 to FIG. 11, and details are not described herein. It should be understood that the integrated heat dissipation metal substrate 510 is obtained through integrated manufacturing, and therefore may be considered as a monolithic component.

502: Weld the chip 520 to the copper layer 513 of the integrated heat dissipation metal substrate 510.

Specifically, in this step, the chip 520 may be welded on a surface of a side that is of the copper layer 513 and that is away from the heat sink 511. The copper layer 513 may implement processing of a trace pattern by using a pattern transfer process in a PCB (printed circuit board) factory. For example, a conducting trace and a pad may be formed on the copper layer 513 in an image transfer manner in cooperation with a chemical etching manner, and the chip 520 may be welded on the pad of the copper layer 513.

In some embodiments, this step may further include: establishing 530 an interconnection through wire bonding after the chip 520 is welded, that is, interconnecting through wire bonding the chip 520 and a pad to which the chip is not welded. In this embodiment, the chip 520 and the pad to which the chip is not welded are interconnected through wire bonding, so that an electrical connection between the chip 520 and the copper layer 513 can be implemented.

It should be understood that, to implement electrical signal transmission between chips, the chips may also be interconnected through wire bonding.

Wire bonding may be understood as pressure welding, binding, bonding, and wire welding, and refers to completing a connection between interconnection traces inside a solid-state circuit in a microelectronic component by using a metal wire (such as a gold wire or an aluminum wire) and a thermocompression or ultrasonic energy, that is, a connection between a chip and a circuit or a lead frame.

503: Package the chip 520 by using the packaging element 540.

In this step, the packaging element 540 may be used to package the chip 520, that is, a packaging process (for example, a plastic packaging process or a glue potting process) may be used to package the chip 520 in plastic. It should be understood that, when the chip 520 is packaged, references may be made to FIG. 7, that is, a single chip and a copper layer connected to the single chip may be packaged; or the chip 520 and the copper layer 513 may be packaged as a whole; or the chip 520, the copper layer 513, and the thermally conductive medium layer 512 may be packaged as a whole, that is, the entire heat dissipation metal substrate may be packaged. Specifically, a selection may be made according to a product requirement.

It should be noted that, when the packaging element 540 is used to package the chip 520, a packaging manner may include a packaging manner such as plastic packaging, glue potting, and glue dispensing, and a confined space is formed outside the chip 520 to prevent the chip 520 from being exposed, thereby protecting the chip 520 and avoiding accidental damage to the chip 520 in a running process.

It should be noted that, when the chip 520 is packaged by using a packaging process, various packaging manners may be used, including but not limited to a SOP (small outline package), a DIP (dual-in-line package), and the like.

The SOP package is an element package form, is one of common surface mount packages, and is mainly used in various integrated circuits. Common packaging materials for the SOP package include plastic, ceramic, glass, metal, and the like. Plastic and ceramic packaging materials are widely used.

The DIP package is a package manner of an integrated circuit. The integrated circuit is rectangular in shape and has two rows of parallel metal pins on both sides, which are referred to as pin rows. An element packed by using the DIP may be welded in a plated through-hole in a PCB board, or inserted into a DIP socket. Therefore, when this package manner is used, through-hole welding of the PCB board can be conveniently implemented, showing well compatibility with a mainboard. However, because a packaging area and a thickness thereof are both relatively large, and the pin is easily damaged during a plugging and unplugging process, reliability is relatively poor.

In some embodiments, before this step is performed, the manufacturing method may further include: welding a pin, where one end of the pin is electrically connected to the pad on the copper layer 513, and the other end of the pin is configured to be electrically connected to a circuit board. It should be understood that an electrical connection between an internal chip of the power module and an external component (for example, a PCB board) can be implemented by disposing a pin.

In an example, as shown in (a) in FIG. 8, if the SOP package is used, the pin 550 may pass through the packaging element 540 and be led out in a seagull wing shape, one end of the pin 550 may be electrically connected to the pad on the copper layer 513, and the other end of the pin 550 may be electrically connected to the PCB board.

In another example, as shown in (b) in FIG. 8, if the DIP package is used, the pin 560 may pass through the packaging element 540 and be disposed outward in parallel, one end of the pin 560 may be electrically connected to the pad on the copper layer 513, and the other end of the pin 560 may be electrically connected to the PCB board.

It should be understood that, after step 501 to step 503 are performed and the entire power module is processed, the power module may be cut to form an independent integrated heat dissipation metal substrate packaging module.

It should be noted that, the manufacturing method for the power module 500 may also be simply summarized as: manufacturing of an integrated heat dissipation metal substrate -welding of a chip -plastic packaging. Compared with the manufacturing methods in FIG. 1 to FIG. 4, an assembly step is reduced. In this embodiment of this application, functions such as circuit connection, heat dissipation, and insulation are integrated by directly using the integrated heat dissipation metal substrate, thereby reducing an assembly process of connecting a power component to a heat sink, reducing a connection interface, and resolving a heat dissipation problem caused by an interface defect. In addition, because incoming materials are integrated, management costs of a power component, a heat sink, a thermally conductive insulation medium, and a fixture and a curing device used in the assembly process are reduced.

FIG. 9 to FIG. 11 describe three different manufacturing methods for an integrated heat dissipation metal substrate according to an embodiment of this application.

FIG. 9 is a diagram of a manufacturing method for an integrated heat dissipation metal substrate according to an embodiment of this application.

801: Obtain a metal substrate 810.

It should be understood that the metal substrate 810 is an independent integral structure. The metal substrate 810 may include a copper layer 820, a thermally conductive medium layer 830, and a metal base 840. The copper layer 820, the thermally conductive medium layer 830, and the metal base 840 are sequentially stacked, and the thermally conductive medium layer 830 is connected between the copper layer 820 and the metal base 840.

A thickness of the copper layer 820 is about 0 mm to 2 mm, and the copper layer 820 can be etched to form a conducting trace and a pad. The metal base 840 may be made of a metal material (for example, aluminum or copper), and a thickness thereof may be customized according to a requirement. The thermally conductive medium layer 830 needs to meet thermal conductivity and insulation characteristics, to implement insulation between the upper layer copper layer 820 and the lower layer metal base 840, and form a heat dissipation link from top to bottom.

802: Perform pattern manufacturing on the copper layer 820 of the metal substrate 810 to form a conducting trace and a pad.

In this step, a conducting trace and a pad may be formed (that is, a copper layer 850 may be formed) on the copper layer 820 of the metal substrate 810 in an image transfer manner in cooperation with a chemical etching manner, and the chip 520 may be welded on the pad.

803: Manufacture a heat sink 860 on the metal base 840 of the metal substrate 810.

In this step, a heat sink tooth may be manufactured on the metal base 840 of the metal substrate 810 in a machining or etching manner, to obtain a required tooth-shaped pattern, so as to form the heat sink 860.

It may be understood that, in this step, a heat sink structure such as a pin-shaped heat sink, a fin-shaped heat sink, or a flow channel may be obtained in a machining or etching manner. For a specific structure of the heat sink 860, refer to FIG. 6.

It should be noted that an integrated heat dissipation metal substrate 870 (including the thermally conductive medium layer 830 and the copper layer 850 and the heat sink 860 that are connected to two sides of the thermally conductive medium layer 830) may be formed by performing step 801 to step 803. It should be understood that the integrated heat dissipation metal substrate 870 is the integrated heat dissipation metal substrate 510.

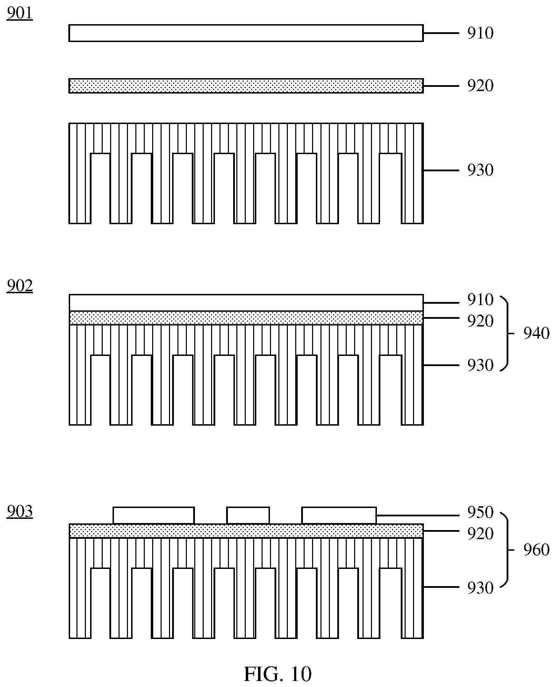

FIG. 10 is a diagram of another manufacturing method for an integrated heat dissipation metal substrate according to an embodiment of this application.

901: Obtain a copper layer 910, a thermally conductive medium layer 920, and a heat sink 930.

It should be understood that, in this step, the copper layer 910, the thermally conductive medium layer 920, and the heat sink 930 may be separately obtained. The thermally conductive medium layer 920 may be made of a polymer composite heat dissipation material. For example, the thermally conductive medium layer 920 may be an epoxy resin layer or a polyimide layer. The heat sink 930 is the heat sink 511, and a material thereof may be copper or aluminum.

It should be noted that, a structure of the heat sink 930 is the same as a structure of the heat sink 511, that is, the heat sink 930 may be formed through processing during original processing. For the structure of the heat sink 930, refer to FIG. 6.

902: Press-fit the copper layer 910, the thermally conductive medium layer 920, and the heat sink 930 to form a heat sink metal substrate 940.

In this step, the copper layer 910, the thermally conductive medium layer 920, and the heat sink 930 that are obtained in step 901 may be press-fitted, so as to form the heat sink metal substrate 940.

It should be understood that a difference between the heat sink metal substrate 940 and the integrated heat dissipation metal substrate 510 lies in that the copper layer 910 on the heat sink metal substrate 940 is not processed to form a conducting trace and a pad.

903: Perform trace pattern manufacturing on the copper layer 910 of the heat sink metal substrate 940 to form a conducting trace and a pad.

It should be understood that, in this step, trace pattern processing may be implemented on the copper layer 910 of the heat sink metal substrate 940 by using a pattern transfer process in a PCB factory, so as to form a conducting trace and a pad (that is, a copper layer 950). For example, a trace pattern may be manufactured on the copper layer 910 in a chemical etching manner, to form a pad and a conducting trace, where the pad may be used to weld a chip.

It should be noted that an integrated heat dissipation metal substrate 960 (including the thermally conductive medium layer 920 and the copper layer 950 and the heat sink 930 that are connected to two sides of the thermally conductive medium layer 920) may be formed by performing step 901 to step 903. It should be understood that the integrated heat dissipation metal substrate 960 is the integrated heat dissipation metal substrate 510.

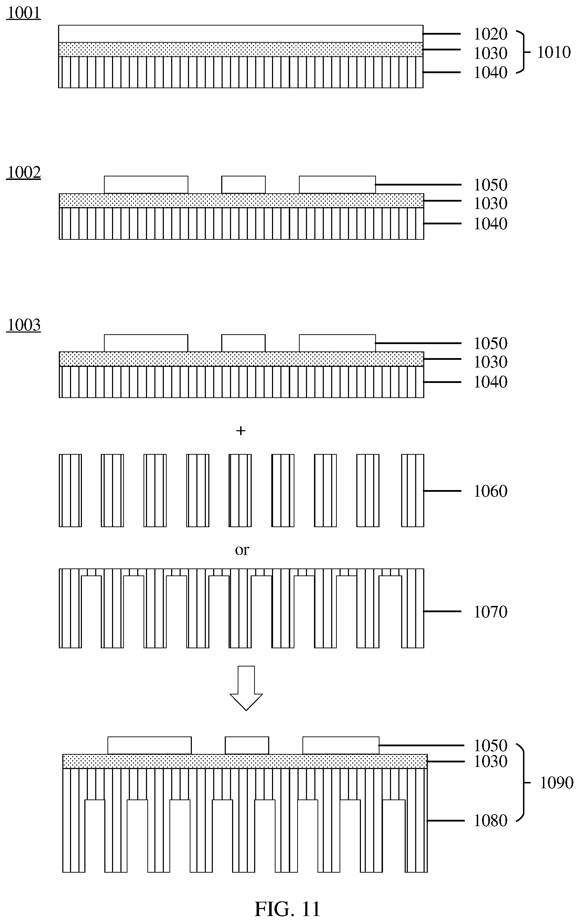

FIG. 11 is a diagram of another manufacturing method for an integrated heat dissipation metal substrate according to an embodiment of this application.

1001: Obtain a metal substrate 1010.

It should be understood that the metal substrate 1010 is an independent integral structure. The metal substrate 1010 may include a copper layer 1020, a thermally conductive medium layer 1030, and a metal base 1040. The copper layer 1020, the thermally conductive medium layer 1030, and the metal base 1040 are sequentially stacked, and the thermally conductive medium layer 1030 is connected between the copper layer 1020 and the metal base 1040.

A thickness of the copper layer 1020 is about 0 mm to 2 mm, and the copper layer 1020 can be etched to form a conducting trace and a pad. The metal base 1040 may be made of a metal material (for example, aluminum or copper), and a thickness thereof may be customized according to a requirement. The thermally conductive medium layer 1030 needs to meet thermal conductivity and insulation characteristics, to implement insulation between the upper layer copper layer 1020 and the lower layer metal base 1040, and form a heat dissipation link from top to bottom.

1002: Perform trace pattern manufacturing on the copper layer 1020 of the metal substrate 1010 to form a conducting trace and a pad.

It should be understood that, in this step, trace pattern processing may be implemented on the copper layer 1020 of the metal substrate 1010 by using a pattern transfer process in a PCB factory, so as to form a conducting trace and a pad (that is, the copper layer 1050). That is, a pattern may be manufactured on the copper layer 1020 in a chemical etching manner, to form a pad and a conducting trace, where the pad may be used to weld a chip.

1003: Fasten the metal base 1040 and a heat sink tooth to form an integrated heat dissipation metal substrate 1090.

In this step, the heat sink tooth may be fastened to the metal base 1040 in a laser welding manner, to form the integrated heat dissipation metal substrate 1090.

In some embodiments, a structure of the heat sink tooth may be shown as 1060 in FIG. 10. The heat sink tooth 1060 may include at least one fin. In this step, the heat sink tooth 1060 and the metal base 1040 may be integrated in a laser welding manner, to form a heat sink 1080, and further form the integrated heat dissipation metal substrate 1090.

In some embodiments, the structure of the heat sink tooth may be shown as 1070 in FIG. 10. The heat sink tooth 1070 may include at least one fin and a connection portion connected to the at least one fin. In this step, the connection portion of the heat sink tooth 1070 and the metal base 1040 may be integrated in a laser welding manner, to form the heat sink 1080, and further form the integrated heat dissipation metal substrate 1090.

It should be noted that the integrated heat dissipation metal substrate 1090 (including the thermally conductive medium layer 1030 and the copper layer 1050 and the heat sink 1080 that are connected to two sides of the thermally conductive medium layer 1030) may be formed by performing step 1001 to step 1003. It should be understood that the integrated heat dissipation metal substrate 1090 is the integrated heat dissipation metal substrate 510.

In addition, an embodiment of this application further provides a power device. The power device is configured to perform alternating current-direct current conversion. The power device may include a circuit board and the power module shown in FIG. 5, or the power device may include a circuit board and a power module manufactured by using the manufacturing method shown in FIG. 8. The power module is disposed on the circuit board.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, comprising: an integrated heat dissipation metal substrate, one or more chips, and a packaging element, wherein
the integrated heat dissipation metal substrate comprises one or more copper layers, a thermally conductive medium layer, and a heat sink, the one or more copper layers, the thermally conductive medium layer, and the heat sink are stacked, the thermally conductive medium layer is connected between the one or more copper layers and the heat sink, and a surface of the thermally conductive medium layer close to the one or more copper layers is parallel to a surface of the thermally conductive medium layer close to the heat sink; and
each chip is connected to a side of one copper layer away from the heat sink, and the packaging element is configured to package the one or more chips.

2. The power module according to claim 1, wherein the thermally conductive medium layer has a consistent thickness and has no intermediate air hole in a thickness direction, and the thickness direction is perpendicular to a contact surface between the thermally conductive medium layer and the heat sink.

3. The power module according to claim 1 or 2, wherein the thermally conductive medium layer comprises a side wall, and the side wall is perpendicular to the contact surface between the thermally conductive medium layer and the heat sink.

4. The power module according to any one of claims 1 to 3, wherein a projection of the thermally conductive medium layer on a first plane completely overlaps a projection of the heat sink on the first plane, and the first plane is the contact surface between the thermally conductive medium layer and the heat sink.

5. The power module according to any one of claims 1 to 4, wherein the thermally conductive medium layer is made of a polymer composite heat dissipation material.

6. The power module according to any one of claims 1 to 5, wherein the packaging element is configured to independently package each chip and the copper layer connected to the chip.

7. The power module according to any one of claims 1 to 5, wherein the packaging element is configured to package the one or more chips and the one or more copper layers as a whole.

8. The power module according to any one of claims 1 to 5, wherein the packaging element is configured to package the one or more chips, the one or more copper layers, and the thermally conductive medium layer as a whole.

9. The power module according to any one of claims 1 to 8, wherein the heat sink is of a pin-shaped structure, or the heat sink is of a fin-shaped structure, or the heat sink is of a flow channel structure.

10. The power module according to any one of claims 1 to 9, wherein the one or more copper layers comprise a first pad and a second pad, the one or more chips are welded to the first pad, and the one or more chips are interconnected to the second pad through wire bonding.

11. The power module according to any one of claims 1 to 9, wherein the one or more copper layers comprise a pad, the power module further comprises a pin that is disposed outward after passing through the packaging element, one end of the pin is electrically connected to the pad, and the other end of the pin is configured to be electrically connected to a circuit board.

12. A manufacturing method for a power module, comprising:
obtaining an integrated heat dissipation metal substrate, wherein the integrated heat dissipation metal substrate comprises one or more copper layers, a thermally conductive medium layer, and a heat sink, the one or more copper layers, the thermally conductive medium layer, and the heat sink are stacked, the thermally conductive medium layer is connected between the one or more copper layers and the heat sink, and a surface of the thermally conductive medium layer close to the copper layer is parallel to a surface of the thermally conductive medium layer close to the heat sink;
welding a chip to a side of the one or more copper layers away from the heat sink; and
packaging the chip by using a packaging element.

13. A power device, wherein the power device is configured to perform alternating current-direct current conversion, the power device comprises a circuit board and the power module according to any one of claims 1 to 11, or the power device comprises a circuit board and a power module manufactured by using the manufacturing method according to claim 12, and the power module is disposed on the circuit board.
